Europäisches Patentamt

European Patent Office

Office européen des brevets

(19)

(11) Veröffentlichungsnummer: **0 138 185**
**B1**

(12) **EUROPÄISCHE PATENTSCHRIFT**

(45) Veröffentlichungstag der Patentschrift: **26.09.90**

(21) Anmeldenummer: **84112087.6**

(22) Anmeldetag: **09.10.84**

(51) Int. Cl.⁵: **H 03 G 3/20, H 04 L 25/52**

(54) Regelstromerzeugung für eine amplitudenabhängige Verstärkungsregelung.

(30) Priorität: **14.10.83 DE 3337525**

(43) Veröffentlichungstag der Anmeldung:
**24.04.85 Patentblatt 85/17**

(45) Bekanntmachung des Hinweises auf die
Patenterteilung:
**26.09.90 Patentblatt 90/39**

(84) Benannte Vertragsstaaten:
**AT BE CH DE FR GB IT LI NL SE**

(56) Entgegenhaltungen:
**EP-A-0 038 435**
**US-A-4 078 157**

(73) Patentinhaber: **Siemens Aktiengesellschaft**
**Wittelsbacherplatz 2**
**D-8000 München 2 (DE)**

(72) Erfinder: **Wendt, Peter, Dipl.-Ing.**
**Oblatterwallstrasse 36c**
**D-8900 Augsburg (DE)**
Erfinder: **Badarau, Theodor-John, Dipl.-Ing.**
**Konrad-Celtis-Strasse 21**
**D-8000 München 70 (DE)**

## Beschreibung

Die Erfindung betrifft eine Anordnung zur Regelstromerzeugung für die amplitudenabhängige Verstärkungsregelung einer Verstärkeranordnung für Impulssignale hoher Impulsfrequenz, mit einer Ankopplung des Ausgangssignals der Verstärkeranordnung, gegebenenfalls nach einer Impulsregeneration, an eine Gleichrichteranordnung, deren Ausgang mit einem Spitzenwertgleichrichter verbunden ist, an den über einen Regelverstärker ein Regeleingang der Verstärkeranordnung angeschlossen ist.

Eine Anordnung zur Regelstromerzeugung der eingangs erwähnten Art ist aus der DE—A—30 15 309 (entspricht EP—A—0 038 435) bekannt. In dieser Offenlegungsschrift wird ein Regenerator für digitale Signale beschrieben, der einen von einem Regelverstärker gesteuerten variablen Entzerrer und außerdem diesem nachgeschaltet einen Amplituden- und einen Zeitregenerator enthält. Mit einem Ausgang des Zeitregenerators ist ein Eingang einer Gleichrichteranordnung in Form einer Transistorverstärkerstufe verbunden, deren Basisvorspannung so eingestellt ist, daß sich neben der Verstärkerfunktion die Funktion eines Halbwellengleichrichters ergibt. Über einen RC-Hochpaß ist mit dieser Transistor-Gleichrichterschaltung ein Spitzenwertgleichrichter verbunden. Dem Spitzenwertgleichrichter nachgeschaltet ist ein Regelverstärker, der die eigentliche Regelgröße für den geregelten Entzerrerverstärker, also einen Regelstrom oder eine Regelspannung, erzeugt.

Bei der bekannten Anordnung wird als Koppelglied zwischen dem Halbwellengleichrichter und dem Spitzenwertgleichrichter ein RC-Hochpaß verwendet, der aus einem Koppelkondensator und einem Widerstand besteht und dessen Zeitkonstante wesentlich größer als die Dauer der Signalimpulse ist. Durch diese Bemessung bleibt die Form der Impulse am Ausgang des RC-Hochpaßgliedes erhalten, durch die Unterdrückung von Gleichspannungsanteilen schwankt die Amplitude in Abhängigkeit vom Tastverhältnis. Dadurch wird der Ladekondensator $C_L$ des Spitzenwertgleichrichters nicht auf den Spitzenwert $U_S$ der Signalimpulse aufgeladen, der am Kollektoranschluß des Halbwellengleichrichters vorliegt. Die Aufladung des Ladekondensators erfolgt auf eine Spannung U', wobei

$$U'=U_s\left(1-\frac{t}{T}\right)$$

ist. Der Quotient aus der effektiven Impulsdauer t und der maximalen Impulsdauer T gibt dabei das Tastverhältnis an. Die vom Spitzenwertgleichrichter am Ladekondensator erzeugte Richtspannung ist also vom Tastverhältnis der Impulssignale und damit, sofern es sich um digitale Sig·· e handelt, vom jeweiligen Bitmuster abhängig. Entsprechend der jeweiligen Impulsdichte ergeben sich also im Regelkreis Schwankungen des Signalpagels und damit Entzerrungsfehler.

Die Aufgabe bei der vorliegenden Erfindung besteht also darin, den Einfluß des Tastverhältnisses der Signalimpulse auf die Regelgröße, also beispielsweise den Regelstrom oder die Regelspannung, zu verringern. Erfindungsgemäß wird die Aufgabe dadurch gelöst, daß der Spitzenwertgleichrichter direkt an einen Ausgang der Gleichrichteranordnung angeschlossen ist, daß der Regelverstärker einen rückgekoppelten Differenzverstärker mit einem invertierenden und einem nichtinvertierenden Eingang enthält, daß der eine Eingang mit einer Referenzspannungsquelle und der andere Eingang vergleichsweise niederohmig mit einem Ausgang des Spitzenwertgleichrichters und außerdem vergleichsweise hochohmig mit einem Ausgang der Gleichrichteranordnung galvanisch verbunden ist und daß die obere Grenzfrequenz des Regelverstärkers wesentlich niedriger als die niedrigste Impulsfolgefrequenz der zu verstärkenden Impulssignale ist. Die erfindungsgemäße Lösung bietet den besonderen Vorteil, praktisch keinen zusätzlichen Aufwand gegenüber dem bekannten Stand der Technik zu benötigen; von weiterem Vorteil ist die Tatsache, daß der Regelverstärker und dabei insbesondere der Operationsverstärker nur für vergleichsweise sehr niedrige Frequenzen ausgelegt werden müssen.

Vorteilhafte Weiterbildungen der erfindungsgemäßen Anordnung zur Regelstromerzeugung sind in den Patentensprüchen 2 bis 6 näher beschrieben.

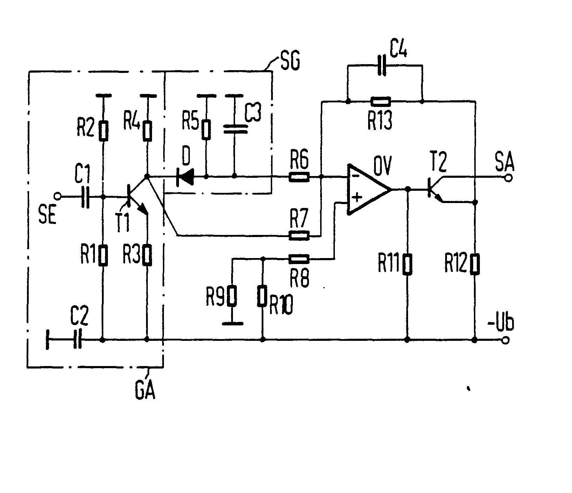

Die Erfindung soll im folgenden an einem in der Zeichnung dargestellten Ausführungsbeispiel näher erläutert werden.

Das in der Zeichnung dargestellte Ausführungsbeispiel einer Anordnung zur Regelstromerzeugung dient analog der Anordnung nach dem Stande der Technik zur Erzeugung eines Regelstroms für einen garegelten Entzerrer, der zur Entzerrung von digitalen Signalen dient, die bei Bitraten von einigen 100 Mbit/s über ein Koaxialkabel übertragen werden. Die Signale liegen wie bei der Anordnung nach dem Stande der Technik im AMI-Code vor, so daß auch die vorgestellte Anordnung zur Regelstromerzeugung eingangsseitig eine Gleichrichteranordnung GA enthält, die als Halbwellengleichrichter wirkt. Wie beim Stande der Technik ist mit dem Signaleingang SE über einen ersten Kondensator C1 der Basisanschluß eines ersten Transistors angekoppelt, der außerdem eine Vorspannung über einen, aus einem ersten und einem zweiten Widerstand R1, R2 gebildeten und mit Betriebsspannung −Ub verbundenen Basisspannungsteiler enthält. Die Betriebsspannung ist im Bereich der Gleichrichteranordnung GA über einen zweiten Kondensator C2 mit Bezugspotential verbunden. Der Emitteranschluß des ersten Transistors T1 ist über einen dritten Widerstand mit Betriebsspannung −Ub verbunden, während der Kollektoranschluß dieses Transistors über einen vierten Widerstand R4 mit Bezugspotential verbunden ist. Außerdem ist dieser Kollektoranschluß über eine Parallelschaltung mit dem invertierenden Eingang (−) eines Differenzverstärkers OV verbunden, die Parallelschaltung besteht aus zwei Zweigen, der erste Zweig wird durch die Reihenschaltung einer Diode D und eines sechsten Widerstandes R6 und der zweite Zweig durch einen siebten Widerstand R7 gebildet. In die Verbindung zwischen Diode D und sechstem Widerstand R6 sind nach Bezugspotential ein dritter Kondensator C3 und ein fünfter Widerstand R5 geschaltet, die so bemessen sind, daß sich in Verbindung mit der Diode D ein Spitzenwertgleichrichter SG ergibt. Der Widerstandswert des sechsten Widerstandes R6 ist vergleichsweise gering gegenüber dem des siebten Widerstandes R7, das Widerstandsverhältnis ist beim Ausführungsbeispiel etwa 1:10.

Zur Erzeugung einer Referenzspannung ist mit der Betriebsspannung −Ub ein zweiter Spannungsteiler verbunden, der durch einen neunten oder einen zehnten Widerstand R9, R10 gebildet ist und dessen Abgriff über einen achten Widerstand R8 mit dem nichtinvertierenden Eingang (+) des Differenzverstärkers OV verbunden ist. Der Differenzverstärker OV wird durch einen handelsüblichen Operationsverstärker gebildet, sein Ausgangsanschluß ist über einen elften Widerstand R11 mit Betriebsspannung −Ub und außerdem mit dem Basisanschluß eines zweiten Transistors T2 verbunden. Der Kollektoranschluß dieses Transistors stellt den Signalausgang SA dar, während der Emitteranschluß über einen zwölften Widerstand R12 mit Betriebsspannung −Ub und über die Parallelschaltung eines dreizehnten Widerstandes R13 und eines vierten Kondensators C4 mit dem invertierenden Eingang des Differenzverstärkers OV verbunden ist. Der zweite Transistor T2 dient zur Impedanzanpassung, während die Parallelschaltung aus dem vierten Kondensator C4 und dem dreizehnten Widerstand R13 als Gegenkopplungsglied wirkt, das die wirksame obere Grenzfrequenz des Differenzverstärkers bis auf etwa 100 Hz begrenzt.

Zur Erläuterung der Wirkungsweise der erfindungsgemäßen Schaltungsanordnung werden zunächst die Ströme und Spannungen im Basis- und Kollektorkreis des ersten Transistors T1 betrachtet. Dieser Transistor ist durch die Auslegung des Basisspannungsteilers so vorgespannt, daß er nur durch die positiven AMI-codierten Eingangssignalimpulse aufgesteuert wird und am Kollektoranschluß einen entsprechenden negativen Spannungsimpuls abgibt. Die Amplitude dieses Spannungsimpulses wird vom Spitzenwertgleichrichter festgestellt. Bei einem positiven Eingangsimpuls erfolgt die Aufladung des ersten Kondensators C1 über einen Widerstand, der sich aus der Summe des Signalquellenwiderstandes und der Parallelschaltung des wirksamen Spannungsteilerwiderstandes zum dynamischen Widerstand der durchgeschalteten Basis-Emitterdiode des Transistors ergibt. Bei negativen Eingangsimpulsen sperrt die Basis-Emitterdiode, so daß sich dann der Koppelkondensator C1 über einen vergleichsweise größeren Widerstand entlädt, der sich aus der Summe des wirksamen Basisteilerwiderstandes und des Signalquellenwiderstandes ergibt. Dadurch ist die Entladezeitkonstante an der Eingangsseite der Gleichrichteranordnung GA stets größer als die Aufladezeitkonstante, so daß sich der Koppelkondensator C1 auf eine bestimmte Spannung auflädt. Diese Spannung ist das Integral über die Ladestromimpulse innerhalb einer bestimmten Zeit und damit direkt von der Zahl der positiven Eingangsimpulse, also vom Bitmuster der übertragenen digitalen Signale, abhängig. Die Spannung an der Basis des ersten Transistors T1 ergibt sich also durch vektorielle Subtraktion der Ladespannung am ersten Kondensator C1 von der Eingangsspannung der Anordnung. Damit ist die Spannung am Basisanschluß des Transistors T1 abhängig von der Dichte der im Eingangssignal enthaltenen positiven Impulse, also von der Dichte der logischen Einsen im Eingangssignal. Bei hoher Einserdichte ist damit die Amplitude der Steuerspannung an der Basis des Transistors T1 kleiner als bei niedriger Einsersichte. Bei Aussteuerung des Halbwellengleichrichters mit einer Quasi-Zufallsfolge, die bei genügender Länge zu 50% aus logischen Einsen besteht, ergibt sich eine Mittelung und damit eine mittlere Ladespannung am Koppelkondensator C1. Der Signalpegel am Eingang des Halbwellengleichrichters vor dem Koppelkondensator C1 das Steuersignal an der Basis und auch der Spannungsimpuls am Kollektoranschluß des ersten Transistors sind dann auf einem Mittelwert, der im vorliegenden Ausführungsbeispiel den Nennwert darstellt. Auch am Ausgang des Spitzenwertgleichrichters SG und damit im gesamten Regelkreis stellt sich ein Nennwert ein.

Für die weiteren Überlegungen wird davon ausgegangen, .daß ein kleinerer Regelstrom zu einer geringeren Dämpfung des regelbaren Entzerrers führen soll und entsprechend ein größerer Regelstrom zu einer größeren Dämpfung.

Bei einer Aussteuerung des Halbwellengleichrichters mit einem Dauereinssignal hat die Einserdichte ihren Maximalwert und ebenfalls die Ladespannung am Koppelkondensator C1. Damit ist aber die wirksame Steuerspannung am Basisanschluß und damit auch der erzeugte Spannungsimpuls am Kollektoranschluß kleiner als der entsprechende Nennwert, der sich bei Quasi-Zufallsfolgen ergibt.

Da die mittels des Spannungsteilers aus dem neunten und zehnten Widerstand R9, R10 gebildete Bezugsspannung gleichbleibt, wird am Signalausgang SA ein Regelstrom abgegeben, der kleiner als beim Nennwert ist. Entsprechend ergibt sich bei einer Ansteuerung der Gleichrichteranordnung GA mit einem Bitmuster geringer Einserdichte eine geringe Aufladung des Koppelkondensators C1 und damit schließlich ein Regelstrom am Signalausgang SA, der größer als bei einem Eingangssignal entsprechend einer Quasi-Zufallsfolge ist. Diese Bitmusterabhängigkeit der eingangsseitigen Gleichrichteranordnung GA ist durch den Koppelkondensator C1 bedingt, der nicht entfallen kann. Entsprechend der Erfindung wird diese Bitmusterabhängigkeit durch die der Gleichrichteranordnung GA nachgeschalteten Anordnungen drastisch verringert. Die Zuführung von Signalen mit unterschiedlicher Einserdichte hat entsprechend den vorstehenden Ausführungen gezeigt, daß der zeitliche Mittelwert U' der Spannungsimpulse im Kollektoranschluß des ersten Transistors T1 mit der Einserdichte des Eingangssignals korreliert und dementsprechend bei maximaler Einserdichte am größten und bei minimaler Einserdichte am kleinsten ist. Entsprechend der Erfindung wird nun unter Wegfall des RC-Hochpasses gemäß dem Stande der Technik zusätzlich zur Richtspannung des Spitzenwertgleichrichters SG der zeitliche Mittelwert der Spannung am Kollektoranschluß des ersten Transistors T1 über einen hochohmigen Widerstand R7 dem invertierenden Eingang des Differenzverstärkers OV zugeführt. Damit ändert sich die Ausgangsspannung des Differenzverstärkers OV nunmehr auch in Abhängigkeit von der Einserdichte des Eingangssignals, so daß die bitmusterabhängige Schwankung der Richtspannung des Spitzenwertgleichrichters SG durch die bitmusterabhängige Schwankung des Mittelwertes der Spannungsimpulse am Kollektoranschluß des Transistors T1 kompensiert wird. Da der Betrag der Richtspannung des Spitzenwertgleichrichters SG mit abnehmender Einserdichte zunimmt, der Betrag des zeitlichen Mittelwertes jedoch abnimmt, müssen zur Kompensation beider Spannungen demselben Eingang des Differenzverstärkers, im Ausführungsbeispiel dem invertierenden Eingang, zugeführt werden.

Am invertierenden Eingang des Differenzverstärkers OV steht eine Steuerspannung an, die sich aus einem hochfrequenten Anteil, der Richtspannung des Spitzenwertgleichrichters und einem niederfrequenten, vom Halbwellengleichrichter stammenden Anteil zusammensetzt. Bei entsprechend niedriger oberer Grenzfrequenz des Differenzverstärkers verstärkt dieser nur den an seinen Anschlüssen anstehenden Gleichspannungsmittelwert zur Bildung des gewünschten Regelstromes.

Neben der bereits aus dem geschilderten Stand der Technik bekannten Anwendung zur Regelung von an Koaxialkabel angeschlossene Entzerrerverstärker kann die erfindungsgemäße Anordnung zur Regelstromerzeugung auch bei Verstärkern angewendet werden, die in Verbindung mit einer Lichtwellenleiterstrecke zur Verstärkung des durch die Lichtimpulse erzeugten Fotostroms dienen, entsprechende Verstärker sind auch nach digitalen Schnittstellen oder in Verbindung mit Magnetspeichereinrichtungen vorteilhaft verwendbar.

## Patentansprüche

1. Anordnung zur Regelstromerzeugung für die amplitudenabhängige Verstärkungsregelung einer Verstärkeranordnung für Impulssignale hoher Impulsfolgefrequenz, mit einer Ankopplung des Ausgangssignals der Verstärkeranordnung, gegebenenfalls nach einer Impulsregeneration, an eine Gleichrichteranordnung (GA) deren Ausgang mit einem Spitzenwertgleichrichter (SG) verbunden ist, an den über einen Regelverstärker (OV) ein Regeleingang der Verstärkeranordnung angeschlossen ist, dadurch gekennzeichnet, daß der Spitzenwertgleichrichter (SG) direkt an einen Ausgang der Gleichrichteranordnung (GA) angeschlossen ist, daß der Regelverstärker einen rückgekoppelten Differenzverstärker (OV) mit einem invertierenden und einem nichtinvertierenden Eingang enthält, daß der eine Eingang mit einer Referenzspannungsquelle und der andere Eingang vergleichsweise niederohmig mit einem Ausgang des Spitzenwertgleichrichters (SG) und außerdem vergleichsweise hochohmig mit einem Ausgang der Gleichrichteranordnung (GA) galvanisch verbunden ist und daß die obere Grenzfrequenz des Regelverstärkers wesentlich niedriger als die niedrigste Impulsfolgefrequenz der zu verstärkenden Impulssignale ist.

2. Anordnung nach Patentanspruch 1, dadurch gekennzeichnet, daß der nichtinvertierende Eingang des Differenzverstärkers (OV) mit der Referenzspannungsquelle und der invertierende Eingang mit dem Ausgang des Spitzenwertgleichrichters und mit dem Ausgang der Gleichrichteranordnung (GA) angeschlossen ist.

3. Anordnung nach Patentansprüchen 1 oder 2, dadurch gekennzeichnet, daß der invertierende Eingang des Differenzverstärkers (OV) mit einem Kollektoranschluß eines Transistors (T1) der Gleichrichteranordnung (GA) verbunden ist.

4. Anordnung nach Patentanspruch 1, dadurch gekennzeichnet, daß die obere Grenzfrequenz des Regelverstärkers etwa um den Faktor $10^{-6}$ unterhalb der niedrigsten Impulsfolgefrequenz der zu verstärkenden Signale liegt.

5. Anordnung nach Patentansprüchen 1, 2 oder 3, dadurch gekennzeichnet, daß der invertierende Eingang des Differenzverstärkers (OV) über einen Widerstand von etwa 1 MOhm an die Gleichrichteranordnung (GA) und über einen Widerstand von etwa 100 KOhm an den Spitzenwertgleichrichter (SG) angeschlossen ist.

6. Anordnung nach einem der Patentansprüche 1 bis 5, dadurch gekennzeichnet, daß dem Regelverstärker eine Impedanzwandlerstufe (T2) nachgeschaltet ist.

## Revendications

1. Agencement pour la production d'un courant de régulation pour le réglage du gain, en fonction de l'amplitude, d'un dispositif amplificateur pour des signaux impulsionnels à fréquence de répétition élevée des impulsions, avec un couplage du signal de sortie du dispositif amplificateur, éventuellement après une régénération des impulsions, avec un dispositif redresseur (GA) dont la sortie est reliée à un redresseur de la valeur de crête (SG), auquel est reliée, par l'intermédiaire d'un amplificateur de réglage (OV), une entrée de réglage du dispositif amplificateur, caractérisé par le fait que le redresseur des valeurs de crête (SG) est relié directement à une sortie du dispositif redresseur (GA), que l'amplificateur de réglage comporte un amplificateur différentiel (OV) monté en rétroaction et possédant une entrée inverseuse et une entrée non inverseuse, que la première entrée est reliée à une source de tension de référence et l'autre entrée est reliée galvaniquement, et avec une valeur ohmique relativement faible à une sortie du redresseur des valeurs de crête (SG) et, en outre, et avec une valeur ohmique relativement élevée, à une sortie du dispositif redresseur (GA), et que la fréquence limite supérieure de l'amplificateur de réglage est notablement inférieure à la plus faible fréquence de répétition des impulsions des signaux impulsionnels à amplifier.

2. Agencement selon la revendication 1, caractérisé par le fait que l'entrée non inverseuse de l'amplificateur différentiel (OV) est reliée à la source de tension de référence, alors que l'entrée inverseuse est reliée à la sortie du redresseur des valeurs de crête et à la sortie du dispositif redresseur (GA).

3. Agencement selon les revendications 1 ou 2, caractérisé par le fait que l'entrée inverseuse de l'amplificateur différentiel (OV) est reliée à la borne de collecteur d'un transistor (T1) du dispositif redresseur (GA).

4. Agencement selon la revendication 1, caractérisé par le fait que la fréquence limite supérieure de l'amplificateur de réglage se situe à peu près d'un facteur $10^{-7}$ en-dessous de la fréquence de répétition des impulsions la plus faible des signaux à amplifier.

5. Agencement selon les revendications 1, 2 ou 3, caractérisé par le fait que l'entrée inverseuse de l'amplificateur différentiel (OV) est reliée, par l'intermédiaire d'une résistance d'environ 1 MOhm, au dispositif redresseur (GA) et, par l'intermédiaire d'une résistance d'environ 100 kOhm, au redresseur des valeurs de crête (SG).

6. Agencement selon l'une des revendications 1 à 5, caractérisé par le fait qu'un étage adaptateur d'impédance (T2) est monté en aval de l'amplificateur de régulation.

**Claims**

1. Arrangement for generating control current for the amplitude-dependent gain control of an amplifier arrangement for pulse signals having a high pulse repetition rate, with a coupling of the output signal of the amplifier arrangement, if necessary after a pulse regeneration, into a rectifier arrangement (GA), the output of which is connected to a peak value rectifier (SG), to which a control input of the amplifier arrangement is connected via a control amplifier (OV), characterized in that the peak value rectifier (SG) is directly connected to an output of the rectifier arrangement (GA), in that the control amplifier contains a feedback differential amplifier (OV) having one inverting and one non-inverting input, in that the one input is electrically connected to a reference voltage source and the other input is connected in a comparatively low-resistance manner to one output of the peak value rectifier (SG), and in addition in a comparatively high-resistance manner to one output of the rectifier arrangement (GA), and in that the upper cut-off frequency of the control amplifier is substantially lower than the lowest pluse repetition rate of the pulse signals to be amplified.

2. Arrangement according to Patent Claim 1, characterized in that the non-inverting input of the differential amplifier (OV) is connected to the reference voltage source, and the inverting input is connected to the output of the peak value rectifier and to the output of the rectifier arrangement (GA).

3. Arrangement according to Patent Claims 1 or 2, characterized in that the inverting input of the differential amplifier (OV) is connected to a collector terminal of a transistor (T1) of the rectifier arrangement (GA).

4. Arrangement according to Patent Claim 1, characterized in that the upper cut-off frequency of the control amplifier lies approximately by the factor of $10^{-6}$ below the lowest pulse repetition rate of the signals to be amplified.

5. Arrangement according to Patent Claims 1, 2 or 3, characterized in that the inverting input of the differential amplifier (OV) is connected via a resistance of approximately 1 Mohm to the rectifier arrangement (GA) and via a resistance of approximately 100 kohm to the peak value rectifier (SG).

6. Arrangement according to one of Patent Claims 1 to 5, characterized in that an impedance converter stage (T2) is connected following the control amplifier.